Europäisches Patentamt

(19) European Patent Office

Office européen des brevets

(11) Numéro de publication: **0 001 538**
**B1**

## (12) FASCICULE DE BREVET EUROPEEN

(45) Date de publication du fascicule du brevet: **12.01.83**

(21) Numéro de dépôt: **78430010.5**

(22) Date de dépôt: **25.08.78**

(51) Int. Cl.³: **H 01 L 21/306,**
**C 23 F 1/02, C 23 C 15/00**

(54) **Procédé de décapage sélectif par ions réactifs d'un élément.**

(30) Priorité: **06.10.77 US 840085**

(43) Date de publication de la demande:
**18.04.79 Bulletin 79/8**

(45) Mention de la délivrance du brevet:
**12.01.83 Bulletin 83/2**

(84) Etats contractants désignés:
**DE FR GB**

(56) Documents cités:
**US - A - 3 940 506**

**JAPAN JOURNAL APPLIED PHYSICS, vol. 16,
no. 1, janvier 1977, Tokyo (Japan) S. MATSUO
et al "Preferential SiO2 Etching on Si Substrate
by Plasma Reactive Sputter Etching" pages
175—176.**

(73) Titulaire: **International Business Machines
Corporation
Armonk, N.Y. 10504 (US)**

(72) Inventeur: **Ephrath, Linda M.
2-8 Vista-on-Lake
Carmel New York 10512 (US)**

(74) Mandataire: **Klein, Daniel
COMPAGNIE IBM FRANCE Département de
Propriété Industrielle
F-06610 La Gaude (FR)**

(56) Documents cités:
**JOURNAL OF THE ELECTROCHEMICAL
SOCIETY-EXTENDED ABSTRACTS, vol. 77-2,
9—14 octobre 1977. Princeton (USA) L. M.
EPHRATH et al. "Selective Etching of Silicon
Dioxide Using Reactive Ion Etching and CF 4-
H2" pages 376—377.**

Courier Press, Leamington Spa, England.

## Procédé de décapage sélectif par ions réactifs d'un élément

### Domaine technique

La présente invention concerne un procédé de décapage par ions réactifs d'un élément tel qu'une tranche semiconductrice composée par un substrat semiconducteur dont une surface est recouverte part une couche isolante choisie dans le groupe comportant l'oxyde et le bioxyde de silicium, le nitrure de silicium, l'oxynitrure de silicium et leurs combinaisons. Cet isolant étant décapé de façon sélective à une vitesse de décapage supérieure à celle du substrat ou d'un matériau résistant si ce dernier est utilisé. La présente invention concerne plus particulièrement les techniques de décapage par ions réactifs dans lesquelles l'élément est disposé sur une cathode qui se trouve portée à un potentiel HF qui assure une autopolarisation continue négative de la cathode vis à vis de l'anode.

### Etat de la technique

Lors de la fabrication des microplaquettes semiconductrices, les étapes de décapage des différentes couches qui constituent en partie la microplaquette, sont parmi les étapes les plus critiques. Une technique de décapage très employée consiste à recouvrir la surface à décaper d'un masque approprié, puis à plonger l'ensemble dans une solution chimique qui attaque ladite surface mais non le masque. Cette technique de décapage chimique dite de type humide présente l'inconvénient de ne pas permettre d'obtenir des surfaces décapées à bords bien définis. Ceci est dû au fait que les produits chimiques provoquent un décapage latéral du masque, par exemple en s'infiltrant sous celui-ci, et continuent alors à attaque la surface à décaper sous des parties recouvertes par le masque.

On utilise également une technique dite de décapage par plasma qui consiste en principe à remplir une enceinte, telle qu'une cloche, d'un gaz dont les ions sont chimiquement réactifs, tel que le $CF_4$. La surface à décaper est recouverte d'un masque et introduite dans cette enceinte. On provoque ensuite une dissociation du gaz en formant ainsi des ions positifs et négatifs, en appliquant une énergie HF au plasma par des moyens capacitifs ou inductifs. Il se produit alors, semble-t-il, une interaction chimique entre les ions ainsi obtenus et la surface à décaper. Les résultats sont disposés sur un plan qui est généralement à la masse. Cette technique présente également l'inconvénient de provoquer un décapage latéral d'une partie des régions recouvertes par le masque.

Encore un autre procédé de décapage de microplaquettes semiconductrices (ou de circuits à films minces) est connu sous l'appelation de décapage par pulvérisation. En général, dans ce dernier procédé, une enceinte telle qu'une cloche est remplie d'un gaz inerte tel que de l'argon. Cette enceinte contient une anode et une cathode. Cette dernière est polarisée négativement par rapport à l'anode, par exemple, en lui appliquant un signal HF. La surface à décaper est recouverte d'un masque approprié, puis est placée sur la cathode. Lorsqu'un potentiel HF est appliqué à cette dernière, le gaz inerte qui se trouve dans la région comprise entre la cathode et l'anode est ionisé et les ions positifs sont attirés vers la cathode. Les ions qui frappent la surface à décaper permettent d'éjecter les atomes de cette dernière, et par conséquent procèdent à un décapage graduel du matériau. Ce procédé de décapage permet d'obtenir des bords mieux définis que dans le cas des procédés de décapage chimique de type humide, mais est relativement lent et prend donc un temps considérable.

Afin de remédier à la lenteur des procédés de décapage par pulvérisation, on a préconisé, notamment dans les brevets des E.U.A. No. 3.971.684 et 3.984.301, l'emploi, comme gaz de décapage, d'un gaz chimiquement réactif tel que le $CF_4$. Lors de l'application d'un champ électrique, il se produit une dissociation du gaz réactif et les ions chimiquement réactifs du gaz sont attirés par la cathode. Le décapage de la surface serait dû à la fois à une interaction chimique avec les ions actifs et au transfert du moment cinétique des ions qui frappent la surface. Cela diffère donc du procédé de décapage par plasma dans lequel seule l'intéraction chimique se produit lors du décapage. Par ailleurs, en raison du fait que le champ électrique les attire vers la cathode, les ions frappent surtout la surface à décaper dans une direction perpendiculaire à cette surface. En conséquence, le procédé dit ciaprès de décapage par ions réactifs permet d'obtenir des régions décapées présentant des parois bien définies verticalement.

Le brevet US—A—3 940 506 décrit un décapage par plasma qui préconise l'emploi d'un mélange d'hydrogène et de fluorocarbone gazeux.

La publication: "Preferential $SiO_2$ Etching on Si Substrate by Plasma Reactive Sputter Etching"; de S. Matsuo et al, publiée dans Japan J.A.P. Vol. 16 (1977), No. 1, page 175 décrit un procédé de décapage sélectif dans un plasma réactif et un équipement de type diode RF, qui mettent en oeuvre $CF_4$ et l'éthylène $C_2H_4$.

Ces deux références, sont les deux antériorités les plus pertinentes connues à ce jour de la demanderesse, et seront analysées plus en détail, ci-après dans la description, après que le procédé de la présente invention ait été complètement exposé.

Un problème majeur posé par le procédé de décapage par ions réactifs réside dans le fait que les gaz réactifs utilisés attaquent également les matériaux de masquage, notamment certains matériaux résistants sensibles à la lumière ou au faisceau électronique, ainsi que certains substrats sousjacents, tels que ceux constitués par du silicium et par divers métaux, ces derniers forment alors des fluorures volatils par exemple des fluorures de titane, de tantale, de molybdène ou de tungstène.

Exposé de la présente invention

La présente invention fournit un procédé sélectif de décapage par ions réactifs qui permet d'obtenir une vitesse de décapage de l'isolant (oxydes de silicium et/ou nitrure de silicium et/ou oxynitrure de silicium) plus rapide que celle du substrat sousjacent ou de la couche de masquage. L'invention fournit également un procédé permettant de commander avec précision le décapage sélectif de l'isolant relativement au substrat ou à la couche de masquage.

On a constaté que grâce à cette augmentation considérable de la vitesse de décapage de l'isolant par rapport à celle du substrat sousjacent, on obtient en outre une interruption naturelle du processus de décapage au niveau du substrat ou des minces régions diffusées.

Le procédé de la présente invention permet donc d'effectuer un décapage rapide par ions réactifs d'un élément qui comprend un substrat, typiquement en matériau semiconducteur recouvert d'une couche isolante en oxyde de silicium et/ou en nitrure de silicium et/ou en oxynitrure de silicium.

Le procédé de l'invention consiste d'abord à placer l'élément à décaper, sur une cathode disposée dans une enceinte, puis à introduire un gaz de décapage approprié.

Ce gaz de décapage se compose d'un mélange d'un composé de fluor et de carbone (fluorocarbone) gazeux capable de fournir des ions réactifs, par exemple des ions $CF_3$, et d'un second gaz capable de fournir de l'hydrogène, c'est-à-dire outre l'hydrogène lui-même l'ammoniac et/ou un hydrocarbure aliphatique gazeux saturé. Le fluorocarbone est présent dans ledit mélange en quantité suffisante pour que l'on puisse obtenir un décapage de la surface du substrat. Le second gaz est également présent en quantité suffisante pour permettre un décapage sélectif de l'oxyde de silicium et/ou du nitrure de silicium et/ou de l'oxynitrure de silicium, à une vitesse supérieure à la vitesse de décapage du substrat et/ou du matériau de masquage si ce dernier est utilisé.

Le fluorocarbone gazeux est présent dans le mélange gazeux en quantité suffisante pour décaper la surface, c'est-à-dire qu'il constitue en principe de 30 à 90% environ, et de préférence de 30 à 75% environ, du débit massique total des gaz.

Le gaz qui fournit l'hydrogène est présent en quantité suffisante pour permettre un décapage sélectif de l'oxyde de silicium et/ou du nitrure de silicium et/ou de l'oxynitrure de silicium, à une vitesse supérieure à la vitesse de décapage du substrat et/ou du matériau photorésistant si ce dernier est employé. En général, le débit de ce second gaz est suffisant pour permettre d'obtenir une quantité d'hydrogène constituant de 10 à 70% environ, et de préférence de 25 à 70% environ, du débit massique total des gaz.

Un potentiel alternatif est appliqué à la cathode afin de provoquer une dissociation des gaz réactifs et d'accélérer chimiquement les ions réactifs du gaz de décapage en direction de la cathode.

D'autres objets, caractéristiques et avantages de la présente invention ressortiront mieux de l'exposé qui suit, fait en référence aux dessins annexés à ce texte, qui représentent un mode de réalisation préféré de celle-ci.

Brève description des figures

La figure 1 est une coupe schématique d'un système utilisable aux fins de la mise en oeuvre du procédé de la présente invention.

La figure 2 est un graphique représentant les vitesses de décapage obtenues pour différents matériaux en fonction de différents pourcentages de $H_2$ dans $CF_4$.

La figure 3 représente un élément caractéristique soumis au procédé de la présente invention.

Description détaillée d'un mode de réalisation préféré

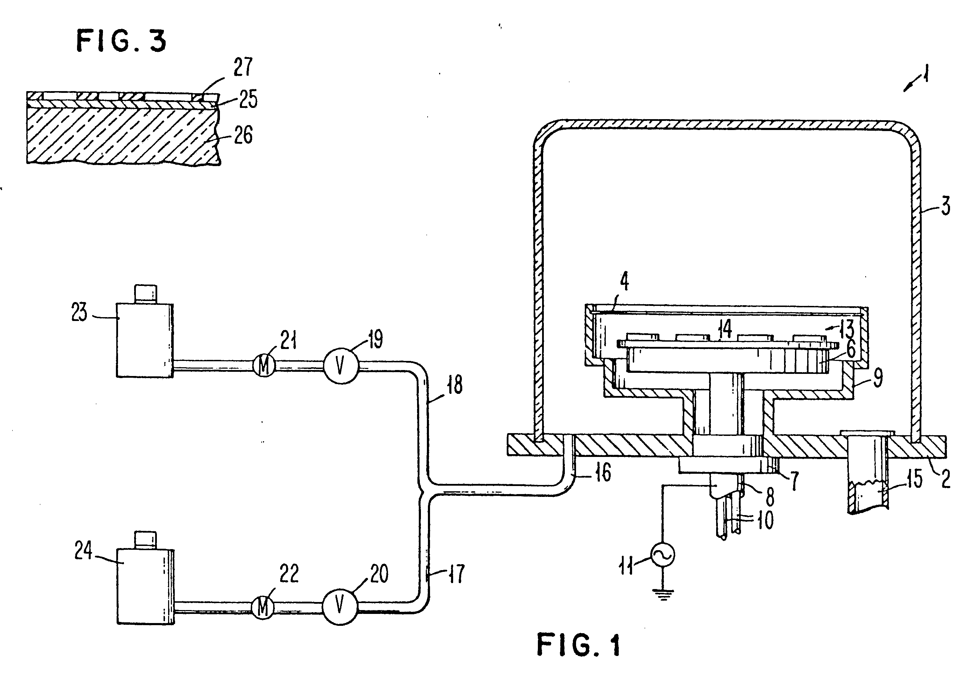

Le système qui est représenté schématiquement sur la figure 1, comporte une enceinte à vide 1 qui comprend une plaque 2 servant de base et une cloche 3 scellée hermétiquement à cette dernière et qui peut être en verre ou en métal. Le volume de l'une des enceintes utilisées dans le cadre de la présente invention était d'environ 15 litres. L'enceinte 1 contient une plaque d'anode 4 et une plaque de cathode 14, disposées l'une en face de l'autre. La plaque de cathode 14 est connectée mécaniquement et électriquement à une cathode 6. Dans certains systèmes, l'enceinte fait fonction d'anode. La cathode est de préférence une électrode HF composée d'une électrode plane 6 pourvue d'un support 8; une entretoise isolante 7 est disposée entre le support 8 et la plaque 2 servant de base afin de maintenir l'électrode 6 dans une position pratiquement parallèle à cette dernière. Elle comprend également un écran 9 destiné à protéger l'électrode 6. Par ailleurs, cette dernière qui est généralement en cuivre, peut être pourvue d'un conduit 10 pour recevoir un fluide de refroidissement permettant éventuellement de refroidir la plaque 14. Un refroidissement peut en effet être souhaitable de manière à éviter que le matériau de masquage ne se dégrade pendant le processus de décapage. Une alimentation alternative 11, qui est de préférence à haute fréquence, est connectée entre le support 8 et la masse. C'est elle qui assure l'autopolarisation continue négative de la cathode.

La plaque d'anode 4 est connectée mécaniquement et électriquement à l'écran 9 et est à la masse. Elle est de préférence disposée à une distance de 2,54 cm environ de la cathode et est perforée. Bien que des densités de courants relativement faibles soient en principe utilisées, il tend à se produire une pulvérisation du matériau constituant la plaque de cathode 14 lorsque ce matériau est un métal tel que l'aluminium, l'acier inoxydable ou le cuivre. En pareil cas, l'anode, grâce à sa position, intercepte le métal ainsi pulvérisé et l'empêche de se diffuser sur la surface qui fait l'objet du décapage.

La figure 1 représente le système pour la mise en oeuvre du procédé de décapage de plusieurs éléments ou articles 13 disposés sur la plaque de cathode 14. La figure 3 représente de façon plus détaillée un élément 13 comportant un substrat 26, revêtu d'une couche d'un matériau à décaper 25 et un masque ou couche de masquage 27.

L'enceinte à vide comprend un tuyau d'évacuation 15 qui permet de faire le vide dans l'enceinte et qui est connecté à un dispositif de pompage (non représenté). On peut donc faire le vide dans l'enceinte avant de soumettre les différents éléments au procédé de la présente invention. L'enceinte comprend également un conduit 16 qui se divise en deux conduits 17 et 18 repectivement pourvus de clapets de décharge 19 et 20 et de débimètres 21 et 22. Chaque ensemble constitué par un clapet de décharge et un débimètre pourrait évidemment être remplacé par un dispositif assurant les mêmes fonctions, par exemple par un dispositif de commande de débit. Le conduit 18 est connecté à un réservoir 23 contenant l'un des gaz cependant que le conduit 17 est connecté au réservoir 24 destiné à contenir l'autre gaz.

Les éléments soumis au procédé de décapage de la présente invention sont constitués par un substrat revêtu par une couche isolante simple ou composite d'un matériau choisi dans le groupe comprenant les oxydes de silicium tel que SiO et $SiO_2$, le nitrure de silicium et l'oxynitrure de silicium. Le substrat peut être constitué par n'importe quel matériau connu utilisé classiquement en décapage par ions réactifs, notamment les matériaux qui ne forment pas de fluorures volatils dans les conditions dans lesquelles le présent procédé est mis en oeuvre. Par ailleurs, lorsque le procédé est employé aux fins de la préparation d'éléments présentant des configurations déterminées, un masque constitué, par exemple, par un matériau sensible à la lumière ou aux électrons est appliqué au-dessus de la couche isolante.

La présente invention permet en outre, du fait de la sélectivité obtenue, d'utiliser comme substrat des matériaux autres que ceux qui sont habituellement employés, en particulier des métaux formant des fluorures volatils: le titane, le tantale, le molybdène et le tungstène, par exemple. Par ailleurs, en raison de la sélectivité qu'elle permet d'obtenir entre la surface à décaper et les matériaux constituant le masque, la présente invention est particulièrement avantageuse dans le cas des procédés dans lesquels un matériau photorésistant est employé quel que soit le type de substrat mis en oeuvre.

Le mélange de gaz de décapage employé conformément à la présente invention comprend un fluorocarbone gazeux capable de fournir des ions $CF_3$, par exemple le $CF_4$, le $CHF_3$ ou le $C_2F_6$. Le fluorocarbone gazeux préféré est le $CF_4$.

Le second composant du mélange gazeux est un gaz capable de fournir de l'hydrogène au plasma sans pour autant introduire d'autres corps réactifs. Les gaz utilisables à cette fin comprennent l'hydrogène, le $NH_4$ et les hydrocarbures aliphatiques saturés sous forme gazeuse tels que le méthane, l'éthane, le propane et le butane. Le gaz préféré est l'hydrogène.

L'hydrogène doit exister sous la forme d'un composant indépendant et distinct de fluorocarbone, même lorsque ce dernier inclut de l'hydrogène. On a observé que l'utilisation d'hydrocarbures fluorés (tels que le $CHF_3$) auxquels on n'aurait pas ajouté de l'hydrogène en tant que constituant distinct, ne convenait pas dans le cadre de la présente invention car, dans les conditions dans lesquelles cette dernière est mise en oeuvre, les vitesses de décapage nécessaires ne pourraient pas être atteintes.

Le fluorocarbone gazeux est présent dans le mélange gazeux en quantité suffisante pour décaper la surface, c'est-à-dire qu'il constitue en principe de 30 à 90% environ, et de préférence de 30 à 75% environ, du débit massique total des gaz.

Le gaz qui fournit l'hydrogène est présent en quantité suffisante pour permettre un décapage sélectif de l'oxyde de silicium et/ou du nitrure de silicium et/ou de l'oxynitrure de silicium, à une vitesse supérieure à la vitesse de décapage du substrat et/ou du matériau photorésistant si ce dernier est employé. En général, le débit de ce second gaz est suffisant pour permettre d'obtenir une quantité d'hydrogène constituant de 10 à 70% environ, et de préférence de 25 à 70% environ, du débit massique total des gaz. En conséquence, lorsque le second gaz n'est pas de l'hydrogène pur, son débit doit être calculé mathématiquement en fonction de la masse relative de H2 dans la molécule du second gaz afin de déterminer le débit qu'il convient d'employer.

On suppose ici que, lors d'un décapage par ions réactifs, les corps réactifs sont essentiellement des ions positifs de $CF_3$ et des radicaux halogènes tels que le fluor. Le fait d'ajouter de l'hydrogène à un plasma de fluorocarbone se traduit par un décapage sélectif de l'oxyde de silicium et/ou du nitrure de silicium et/ou des oxynitrures de silicium en éliminant, par exemple, les radicaux fluor par formation d'acide fluorhydrique. En conséquence, l'ion de fluorocarbone tel que le CF$_3$, qui attaque les oxydes de silicium et le nitrure de silicium, mais non le silicium et les autres matériaux constituant le substrat demeure le corps de décapage prédominant. On obtient de ce fait une vitesse de décapage élevée.

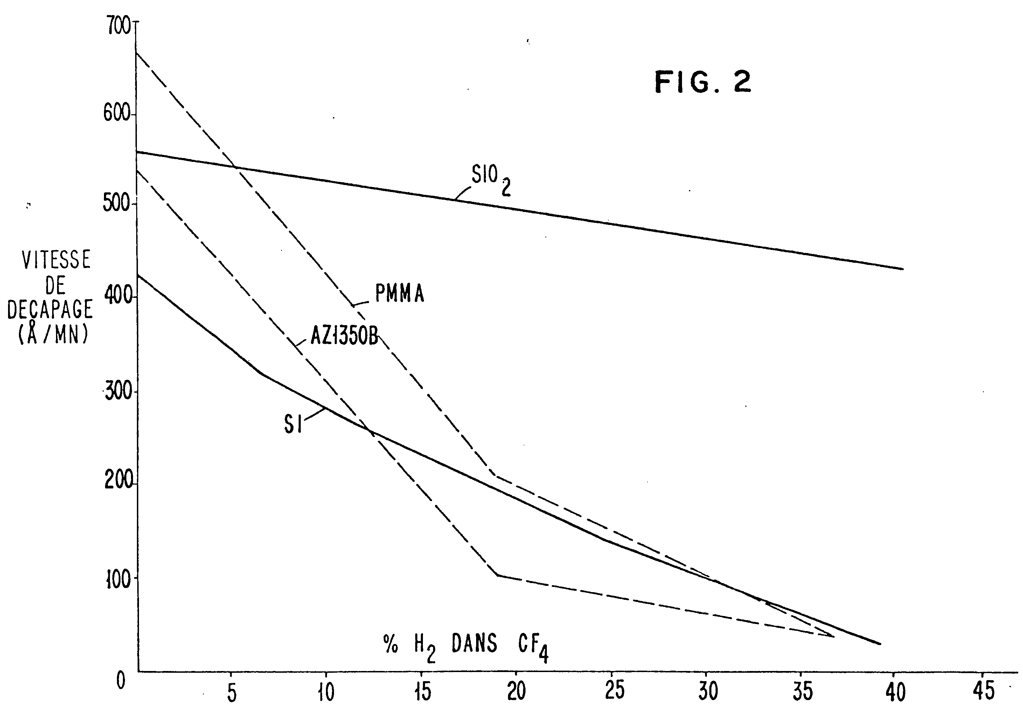

L'emploi de 40% environ en poids de H$_2$ dans du CF$_4$ (figure 2) à une pression de 35 millitors environ et à un débit de 30 cm$^3$/mn environ a permis d'obtenir un rapport de la vitesse de décapage du dioxyde de silicium à la vitesse de décapage du silicium d'environ 35 à 1. Le rapport de la vitesse de décapage du dioxyde de silicium à la vitesse de décapage d'un matériau photorésistant classique tel que le méthacrylate de polyméthyle ou le Shipley AZ 1350B était d'environ 10 à 1. La vitesse de décapage du dioxyde de silicium était d'environ 440 Å/mn. De plus, dans les mêmes conditions, le rapport de la vitesse de décapage du Si$_3$N$_4$ à celle du silicium et des matériaux photorésistants classiques était de 100 et de 20, respectivement, à 1.

L'emploi de gaz dans le présent procédé de décapage par ions réactifs est très différent de celui du mélange d'hydrogène et de fluorocarbone gazeux qui est préconisé, aux fins d'un décapage par plasma, dans le brevet des E.U.A. No. 3 940 506. En effet, dans ce dernier type de décapage, il n'est pas possible d'utiliser des quantités d'hydrogène dépassant 40% car il se produirait alors une polymérisation (voir colonne 2, lignes 48—52). Par ailleurs, le rapport maximum de la vitesse de décapage du dioxyde de silicium à celle du silicium qui est obtenue par le procédé décrit dans ce dernier brevet est de 5 à 1. La présente invention permet d'obtenir des vitesses de décapage nettement plus élevées. Ainsi qu'on l'a précédemment mentionné, le décapage par plasma diffère considérablement du décapage par ions réactifs de la présente invention étant donné que, dans la technique de décapage par plasma, les ions ne sont pas accélérés en direction du substrat car ce dernier est au potentiel de la masse ou du plasma. En revanche, l'accélération obtenue lors d'un décapage par ions réactifs favorise considérablement les interactions chimiques.

La publication de Matsuo mentionnée ci-dessus ne fait pas ressortir le rôle de l'hydrogène contenu dans l'éthylène mais plutôt celui du carbone, puisque dans une autre variante du procédé, on suggère l'emploi d'une cible de carbone destinée à absorber les radicaux libres de fluor. L'utilisation d'une cible en carbone ou en Teflon permet d'améliorer le rapport des vitesses de décapage SiO$_2$ (si dans un rapport compris entre 4 et 7). L'utilisation de l'éthylène apporte une très légère amélioration puisqu'un rapport de 10 peut être obtenu. Cependant, l'obtention de cette valeur implique nécessairement l'utilisation de ce genre de cibles avec les inconvénients (reproductibilité-contaminant) qui en résultent. Enfin l'éthylène ne peut être utilisé qu'en faible quantité en raison de sa tendance à polymériser et par ailleurs l'éthylène peut, selon les conditions opératoires, se décomposer en un grand nombre de constituants. Il semble donc clair que si le rôle de l'hydrogène avait été compris à cette occasion, il aurait été utilisé à la place de l'éthylène.

La présente invention ne couvre pas l'emploi de l'éthylène, qui est un hydrocarbure insaturé, mais exclusivement, l'hydrogène, l'ammoniac et les hydrocarbures aliphatiques saturés.

Du point de vue des résultats enfin, le procédé de la présente invention apparaît très supérieur au procédé Matsuo, selon ce dernier on atteint un rapport des vitesses différentes de décapage SiO$_2$/Si de 10 alors que selon le procédé de la présente invention on atteint un rapport de 35.

Les quantités de gaz utilisées doivent de préférence être régulées en contrôlant les débits massiques respectifs des différents gaz avant que ceux-ci ne soient mélangés. On peut ainsi réguler le débit avec la précision requise pour obtenir un procédé uniforme et reproductible et pour éviter la polymérisation qui pourrait se produire lorsqu'on emploie les quantités importantes d'hydrogène prévues par la présente invention. Les autres procédés qui peuvent être employés pour mesurer les quantités relatives des gaz, par exemple en calculant les pressions partielles, n'offrent pas la précision du procédé de la présente invention, compte tenu des petites erreurs qui peuvent être commises lors des mesures et des fluctuations qui peuvent se produire dans les lignes d'alimentation. Les gaz sont retirés de l'enceinte à vide au moyen d'une pompe appropriée. Lors de certains essais, une pompe à diffusion d'huile refroidie par de l'azote liquide et associée à une pompe mécanique rotative a été utilisée.

Le procédé de la présente invention est généralement mis en oeuvre à des pressions variant entre 5 et 200 millitorrs environ et de préférence, entre au moins 20 et 100 millitorrs environ. Les pressions supérieures à 100 millitorrs environ entraînent généralement une polymérisation aux concentrations d'hydrogène les plus importantes. Des pressions égales à environ 100 millitorrs ou moins sont préférables car elles permettant d'obtenir de meilleurs rapports des vitesses de décapage.

Une densité de puissance commode aux fins de l'utilisation de la source de tension alternative qui fournit la puissance HF, se situe entre 0,05 et 1 environ et de préférence entre 0,1 et 0,5 watts par cm$^2$ de cathode.

Le débit gazeux total est généralement d'au moins 10 cm$^3$/mn. Le débit maximum est essentiellement déterminé par la capacité du système de pompage. Le débit minimum préféré est d'environ 20 cm$^3$/mn. Le débit maximum préféré est d'environ 1.000 cm$^3$/mn.

La vitesse de décapage effective du substrat varie généralement entre 5 Å et 100 Å par minute environ, et celle de la couche d'oxyde de silicium et/ou de nitrure de silicium, entre 250 et 1000 Å/mn. Il est souhaitable que le rapport des vitesses de décapage de l'oxyde de silicium et du nitrure de silicium à celle du substrat soit d'au moins 5 à 1 environ.

Le rapport des vitesses de décapage des oxydes de silicium à celles des matériaux photorésistants classiques est d'au moins 10 à 1, et celui de la vitesse de décapage du nitrure de silicium à la vitesse de décapage des matériaux photorésistants classiques est d'au moins 20 à 1.

Le matériau constituant la plaque de cathode est de préférence un métal tel que l'aluminium car ce métal empêche le matériau photorésistant d'atteindre une température trop élevée et de ramollir. Le métal de la cathode fait fonction de puits de chaleur et, de ce fait, des vitesses de décapage élevées peuvent être atteintes. La cathode peut s'il y a lieu être refroidie par des moyens externes ainsi qu'on l'a précédemment mentionné.

Bien que l'on ait décrit dans ce qui précède et représenté sur les dessins, les caractéristiques essentielles de la présente invention appliquées à un mode de réalisation préféré de celle-ci, il est évident que l'homme de l'art peut y apporter toutes modifications de forme ou de détail qu'il juge utiles, sans pour autant sortir du cadre de ladite invention.

## Revendications

1. Procédé de décapage sélectif par ions réactifs d'un élément constitué par un substrat recouvert par une couche isolante délimitée selon une configuration désirée, du genre comportant l'étape de:

placement du substrat sur la cathode d'un système de décapage par ions réactifs, reliée à une source de tension alternative et caractérisé en ce qu'il comporte en outre l'étape de l'introduction dans le système d'un gaz réactif de décapage composé d'un fluoro-carbone gazeux susceptible de fournir des ions $CF_3$ en quantité suffisante pour assurer le décapage et d'un second gaz qui est l'hydrogène ou un composé susceptible de fournir de l'hydrogène, choisi dans le groupe comprenant $NH_4$ et les hydrocarbures aliphatiques saturés, la quantité d'hydrogène représentant au moins 10% du débit massique total pour assurer d'une part le décapage de la couche isolante à une vitesse supérieure de celle du substrat et d'autre part pour éviter la polymérisation dudit composé susceptible de fournir de l'hydrogène.

2. Procédé de décapage selon la revendication 1 caractérisé en ce que ledit élément comporte en outre une couche de masquage délimitée selon une configuration désirée qui recouvre la couche isolante.

3. Procédé de décapage selon la revendication 1 ou 2 caractérisé en ce que le substrat est choisi dans le groupe comprenant le silicium et les métaux formant avec le fluor, des fluorures volatils.

4. Procédé selon la revendication 3 caractérisé en ce que lesdits métaux comprennent le titane, le tantale, le molybdène et le tungstène.

5. Procédé de décapage selon la revendication 3 caractérisé en ce que le substrat est du silicium.

6. Procédé selon l'une quelconque des revendications ci-dessus caractérisé en ce que le matériau constituant la couche isolante est choisi dans le groupe comprenant l'oxyde et le dioxyde de silicium, le nitrure de silicium et l'oxynitrure de silicium, et leurs combinaisons.

7. Procédé de décapage selon l'une quelconque des revendications ci-dessus caractérisé en ce que lesdits hydrocarbures aliphatiques saturés comprennent le méthane, l'éthane, le propane et le butane.

8. Procédé de décapage selon l'une quelconque des revendications ci-dessus caractérisé en ce que la quantité d'hydrogène représente entre 20 et 40% de débit massique total des gaz.

9. Procédé de décapage selon la revendication 8 caractérisé en ce que le fluorocarbone est du $CF_4$ et que la quantité d'hydrogène représente 40% du débit massique total.

10. Procédé de décapage selon l'une quelconque des revendications ci-dessus caractérisé en ce que la pression qui règne dans le système est comprise entre 5 et 200 millitorrs.

11. Procédé de décapage selon la revendication 10 caractérisé en ce que la pression est comprise entre 10 et 100 millitorrs.

12. Procédé de décapage selon la revendication 11 caractérisé en ce que la pression est de 20 millitorrs.

13. Procédé de décapage selon la revendication 11 ci-dessus caractérisé en ce que la pression est de 35 millitorrs environ et le débit de 30 $cm^3$/mn.

14. Procédé de décapage selon l'une quelconque des revendications ci-dessus caractérisé en ce que la source de tension alternative est une source HF qui fournit entre 0,1 et 0,5 watts environ par $cm^2$ de cathode.

## Patentansprüche

1. Verfahren zum selektiven, reaktiven Ionenätzen eines Substrats, das mit einer nach einem gewünschten Muster abgegrenzten Isolierschicht bedeckt ist, und das folgenden Verfahrensschritt einschließt:

Positionieren des Substrats auf die Kathode eines reaktiven Ionenätzsystems, die mit einer Wechselspannungsquelle verbunden ist, und das außerdem dadurch gekennzeichnet ist, daß es den Verfahrensschritt einschließt, in das System ein reaktives Ätzgas einzuleiten, wobei das Gas aus einem gasartigen Fluorkohlenwasserstoff, der $CF_3$-Ionen in genügend großer Menge liefern kann, um das Ätzen zu gewähr-

leisten, und aus einem zweiten Gas, nämlich Wasserstoff oder einer Verbindung aus der Gruppe von NH₃ und den gesättigten, aliphatischen Kohlenwasserstoffen, die Wasserstoff liefern kann, besteht, und wobei die Wasserstoffmenge wenigstens 10% des gesamten Massendurchflusses darstellt, um einerseits die Isolierschicht bei einer höheren Geschwindigkeit als das Substrat zu ätzen, und um andererseits das Polymerisieren der Verbindung zu vermeiden, die Wasserstoff liefern kann.

2. Ätzverfahren nach Anspruch 1, dadurch gekennzeichnet, daß die Struktur außerdem eine gemäß einem gewünschten Muster strukturierte Maskenschicht einschließt, die die Isolierschicht bedeckt.

3. Ätzverfahren nach Anspruch 1, dadurch gekennzeichnet, daß das Substratmaterial aus einem Material aus der Gruppe von Silicium und solchen Metallen ausgewählt wird, die mit Fluor flüchtige Fluoride bilden.

4. Ätzverfahren nach Anspruch 3, dadurch gekennzeichnet, daß zu den Metallen Titan, Tantal, Molybdän und Wolfram gehören.

5. Ätzverfahren nach Anspruch 3, dadurch gekennzeichnet, daß das Substrat aus Silicium besteht.

6. Ätzverfahren nach einem der vorhergehenden Ansprüche, dadurch gekennzeichnet, daß das Isolierschichtmaterial aus einem Material aus der Gruppe Siliciummonoxid, Siliciumdioxid, Siliciumnitrid und Silicium-Oxinitrid und Kombinationen dieser Verbindungen ausgewählt wird.

7. Ätzverfahren nach einem der vorhergehenden Ansprüche, dadurch gekennzeichnet, daß zu den gesättigten, aliphatischen Kohlenwasserstoffen Methan, Ethan, Propan und Butan gehören.

8. Ätzverfahren nach einem der vorhergehenden Ansprüche, dadurch gekennzeichnet, daß die Wasserstoffmenge zwischen 20 und 40% des gesamten Massendurchflusses der Gase beträgt.

9. Ätzverfahren nach Anspruch 8, dadurch gekennzeichnet, daß der Fluorkohlenwasserstoff aus CF₄ besteht, und daß die Wasserstoffmenge 40% des gesamten Massendurchflusses darstellt.

10. Ätzverfahren nach einem der vorhergehenden Ansprüche, dadurch gekennzeichnet, daß der in dem System herrschende Druck zwischen 6,66 und 266,65 μbar liegt.

11. Ätzverfahren nach Anspruch 10, dadurch gekennzeichnet, daß der Druck zwischen 13,33 und 133,32 μbar liegt.

12. Ätzverfahren nach Anspruch 11, dadurch gekennzeichnet, daß der Druck 26,66 μbar beträgt.

13. Ätzverfahren nach dem obigen Anspruch 11, dadurch gekennzeichnet, daß der Druck ungefähr 46 μbar und die Durchflußgeschwindigkeit 30 cm³/Minute beträgt.

14. Ätzverfahren nach einem der vorhergehenden Ansprüche, dadurch gekennzeichnet, daß die Wechselspannungsquelle eine HF-Quelle darstellt, die zwischen 0,1 und 0,5 Watt/cm² Kathodenfläche liefert.

**Claims**

1. A method for selective reactive ion etching of an element composed of a substrate coated with an insulating layer delineated according to a desired pattern, of the type comprising the step of:

positioning the substrate on the cathode of a reactive ion etching system, said cathode being connected to an AC voltage source, and characterized in that it further comprises the step of introducing into said system a reactive etching gas consisting of gaseous fluorocarbon capable of supplying a sufficient amount of CF₃ ions for the etching process and of a second gas, that is, hydrogen or a constituent capable of supplying hydrogen, selected from the group of NH₄ and saturated aliphatic hydrocarbons, wherein the amount of hydrogen represents at least 10% of the total mass flow rate in order to ensure etching of the insulating layer at a rate higher than that of the substrate on the one hand, and to avoid polymerization of said constituent capable of supplying hydrogen on the other hand.

2. An etching method according to claim 1, characterized in that said element further comprises a mask layer delineated according to a desired pattern deposited on said insulated layer.

3. An etching method according to claim 1 or 2, characterized in that the substrate is chosen from the group of silicon and metals forming with fluorine volatile fluorides.

4. An etching method according to claim 3, characterized in that said metals comprise titanium, tantalum, molybdenum and tungsten.

5. An etching method according to claim 3, characterized in that the substrate consists of silicon.

6. An etching method according to any one of the preceding claims, characterized in that the material forming the insulating layer is selected from the group consisting of oxide and silicon dioxide, silicon nitride and silicon oxynitride, and the combinations thereof.

7. An etching method according to any one of the above claims, characterized in that said saturated aliphatic hydrocarbons include methane, ethane, propane and butane.

8. An etching method according to any one of the above claims, characterized in that the amount of hydrogen represents from 20 to 40% of the total mass flow of the gases.

9. An etching method according to claim 8, characterized in that the fluorocarbon is CF₄ and the amount of hydrogen is 40% of the total mass flow.

10. An etching method according to any one of the above claims, characterized in that the pressure in the system ranges from 5 to 200 millitorr.

11. An etching method according to claim 10, characterized in that the pressure ranges from 10 to 100 millitorr.

12. An etching method according to claim 11, characterized in that the pressure is 20 millitorr.

13. An etching method according to the above claim 11, characterized in that the pressure is about 35 millitorr and the flow rate 30 cm³/minute.

14. An etching method according to any one of the above claims, characterized in that the AC voltage source is an RF source supplying from about 0.1 to 0.5 watt/cm² of cathode.

FIG. 1

FIG. 3

FIG. 2